# DEMANDE DE BREVET EUROPEEN

(11) **EP 0 886 320 A1**
(43) Date de publication de la demande: **23.12.1998**
(21) Numéro de dépôt: 98410068.5
(22) Date de dépôt: 16.06.1998
(51) Int. Cl.: H01L 29/788

(54) **Cellule EEPROM à un seul niveau de silicium polycristallin et zone tunnel auto-alignée**

(30) Priorité: 17.06.1997 FR 9707740
(71) Demandeur: SGS-THOMSON MICROELECTRONICS S.A., 94250 Gentilly (FR)
(72) Inventeur: Mirabel, Jean-Michel, 13480 Cabries (FR)
(74) Mandataire: de Beaumont, Michel

(57) **Abrégé**

L'invention concerne une cellule EEPROM à un seul niveau de silicium polycristallin qui correspond à une grille flottante qui s'étend d'une part, par l'intermédiaire d'une première couche isolante au-dessus d'une région fortement dopée d'un premier type de conductivité constituant une grille de commande (CG), d'autre part, par l'intermédiaire d'une deuxième couche isolante pour former un doigt de grille (D3) au-dessus d'une zone de canal de la cellule. La deuxième couche isolante est une couche suffisamment mince pour donner lieu à un effet tunnel et la zone de drain (13) de la cellule est à profil graduel et s'étend partiellement sous le doigt de grille.

## Description

La présente invention concerne une cellule mémoire de type EEPROM à un seul niveau de silicium polycristallin.

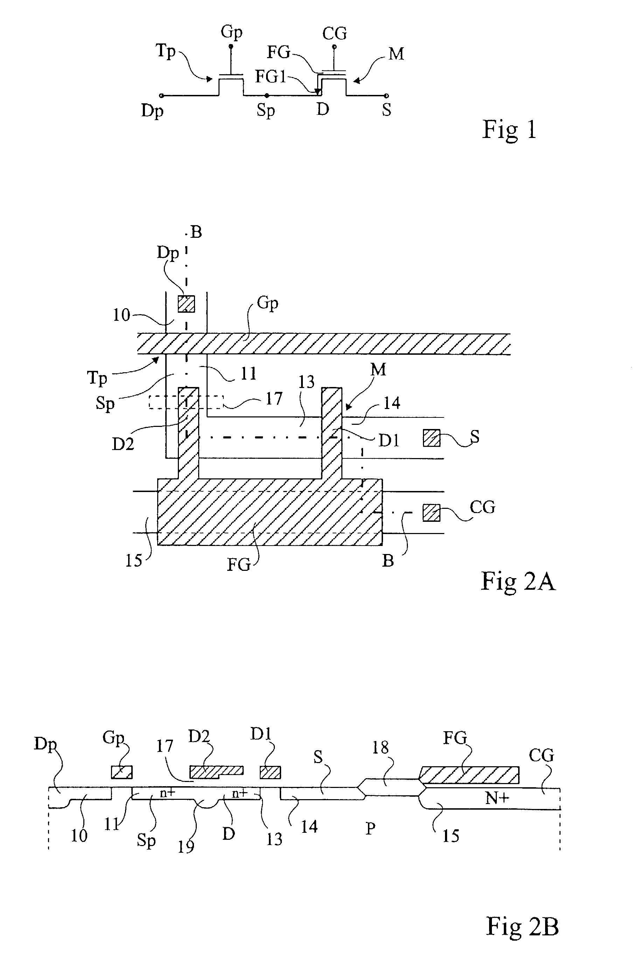

La figure 1 représente sous forme de schéma de circuit une cellule mémoire EEPROM M associée à un transistor de sélection Tp. Le transistor de sélection a un drain Dp une source Sp, et une grille de commande Gp. La cellule mémoire a un drain D connecté à la source Sp du transistor de sélection, une grille flottante FG, une grille de commande CG et une source S. La grille flottante comprend un prolongement FG1 disposé au-dessus d'une région d'oxyde tunnel et destiné à la programmation et à l'effacement de la cellule mémoire M, comme cela sera expliqué plus en détail en relation avec les figures 2A et 2B.

La figure 2A représente une vue de dessus d'un mode de réalisation classique d'une cellule EEPROM à un seul niveau de silicium polycristallin. La figure 2B représente une vue en coupe selon la ligne brisée BB de la figure 2A.

Bien entendu, les figures 2A et 2B sont fortement schématiques et ne sont pas tracées à l'échelle comme cela est usuel dans le domaine de la représentation des composants semiconducteurs.

On se référera ci-après à l'ensemble des figures 2A et 2B. La structure est formée dans un substrat de type P. Le canal du transistor Tp s'étend sous une portion d'une région de silicium polycristallin Gp. De part et d'autre de cette région de canal s'étendent des régions de type N 10 et 11 correspondant respectivement aux régions de drain Dp et de source Sp. La région 11 se prolonge jusqu'à une région 13 correspondant au drain D de la cellule mémoire. De l'autre côté d'un doigt de grille D1 apparaît une région de source 14 de la cellule mémoire. Un contact de drain Dp est pris sur la région 10 et un contact de source S sur la région 14. Les régions 10, 11, 13, 14 sont délimitées par des zones d'oxyde épais.

Le doigt de grille D1 s'étend à partir d'une partie principale de grille flottante FG, en silicium polycristallin, qui repose sur une couche isolante formée sur une région 15 fortement dopée de type N correspondant à la grille de commande de la cellule mémoire et sur laquelle est pris un contact de grille de commande CG. En figure 2B, la référence 18 désigne une zone d'oxyde épais séparant la région 14 de la région 15. En outre, pour la programmation et l'effacement de la cellule mémoire, il est prévu un deuxième doigt D2 s'étendant à partir de la zone de silicium polycristallin FG. Le doigt D2 s'étend au-dessus d'une partie de la région de type N 11, 13 et notamment au-dessus d'une région 17 appelée "zone tunnel" correspondant à un oxyde très mince à travers lequel peut se produire un effet tunnel. On notera que toutes les régions de silicium polycristallin résultent de la gravure d'une même couche de silicium polycristallin.

Cette cellule fonctionne de la façon suivante.

Pour placer des électrons dans la grille flottante, ce qui correspond à un état effacé, on place la grille de commande CG de la cellule M et la grille Gp du transistor de sélection Tp à une tension haute de programmation VPP (par exemple 15 volts), tandis que le drain Dp et la source S sont mis à la masse. Alors, le transistor Tp est passant et des électrons transiteront à travers la couche d'oxyde tunnel dans le doigt D2, c'est-à-dire dans la grille flottante FG. Dans cet état effacé, la cellule M est normalement bloquée.

Pour placer des trous dans la grille flottante, ce qui correspond à un état programmé, on place la grille Gp du transistor de sélection à VPP, ce qui le rend passant, la grille de commande CG est mise à tension basse (la masse), la borne Dp à VPP et la borne S est maintenue flottante. Alors, des trous passent à travers la zone d'oxyde tunnel 17 dans le doigt D2 et sur la grille flottante. Dans cet état programmé, la cellule M est normalement passante.

Pour la lecture de la cellule, on rend le transistor de sélection passant en mettant sa grille Gp à la tension d'alimentation VDD, par exemple 5 volts, et le drain Dp est polarisé positivement par rapport à la source S (par exemple 2 volts et 0 volt). La grille de commande CG est mise à 5 volts. Si la cellule est à l'état effacé, aucun courant ne circulera de Dp à S. Si la cellule est à l'état programmé, un courant passera de Dp à S. On comprendra que le transistor de sélection est utilisé pour bloquer tout passage de courant lorsque la grille flottante est chargée de trous (état programmé) et qu'elle n'est pas adressée en lecture.

La structure de cette cellule et sa fabrication sont relativement complexes. Ceci est essentiellement dû au fait qu'il faut éviter tout claquage de grille pendant les phases de lecture et donc que le doigt D1 de la grille flottante disposé au-dessus du canal de la cellule mémoire est formé au-dessus d'un oxyde relativement épais pour assurer une tenue en tension suffisante.

On a donc été amené dans l'art antérieur, comme cela a été indiqué précédemment à séparer la fonction de canal de la cellule mémoire (doigt D1) de la fonction de programmation par effet tunnel de la cellule mémoire (doigt D2), ce qui conduit à une augmentation de surface. En outre, la formation de la "zone tunnel" est relativement complexe car elle nécessite la superposition de plusieurs masques qui ne sont pas auto-alignés : le masque d'implantation d'une zone de type N fortement dopée 19 sous l'oxyde tunnel (voir figure 2B), le masque de la région d'oxyde tunnel définissant la zone d'oxyde amincie où se fait la circulation de charge pour la programmation ou l'effacement, et le masque du doigt de silicium polycristallin D2 vers lequel s'opère le passage des charges.

Ainsi, la présente invention propose une nouvelle structure de cellule EEPROM à un seul niveau de silicium polycristallin dans laquelle la zone tunnel est auto-alignée par rapport à la grille flottante.

Un autre objet de la présente invention est de prévoir une cellule mémoire EEPROM à un seul niveau de silicium polycristallin de surface plus faible que celle des cellules antérieures.

Pour atteindre ces objets, la présente invention prévoit une cellule EEPROM à un seul niveau de silicium polycristallin qui correspond à une grille flottante qui s'étend d'une part, par l'intermédiaire d'une première couche isolante au-dessus d'une région fortement dopée d'un premier type de conductivité constituant une grille de commande, d'autre part, par l'intermédiaire d'une deuxième couche isolante pour former un doigt de grille au-dessus d'une zone de canal de la cellule. Dans cette cellule, la deuxième couche isolante est une couche suffisamment mince pour donner lieu à un effet tunnel et la zone de drain de la cellule est à profil graduel et s'étend partiellement sous le doigt de grille.

Selon un mode de réalisation de la présente invention, la zone de source de la cellule est également à profil graduel et s'étend partiellement sous le doigt de grille.

Selon un mode de réalisation de la présente invention, la deuxième couche isolante est une couche d'oxyde de silicium d'une épaisseur de 50 à 80 nm.

Selon un mode de réalisation de la présente invention, les zones de source et de drain résultent d'une implantation de phosphore à une première dose et d'arsenic à une deuxième dose plus élevée que la première dose, ces implantations étant suivies d'un recuit de redistribution de sorte que des atomes dopants de phosphore pénètrent sous les bords de la grille.

Selon un mode de réalisation de la présente invention, la première dose est de l'ordre de quelques 10¹⁴ at./cm² et la deuxième dose de l'ordre de quelques 10¹⁵ at./cm².

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente le schéma d'une cellule EEPROM classique à un seul niveau de silicium polycristallin associée à un transistor de sélection ;
les figures 2A et 2B représentent une vue de dessus et une vue en coupe schématique d'une cellule EEPROM à un niveau de silicium polycristallin selon l'art antérieur ; et
les figures 3A et 3B représentent une vue de dessus et une vue en coupe schématique d'une cellule EEPROM selon la présente invention.

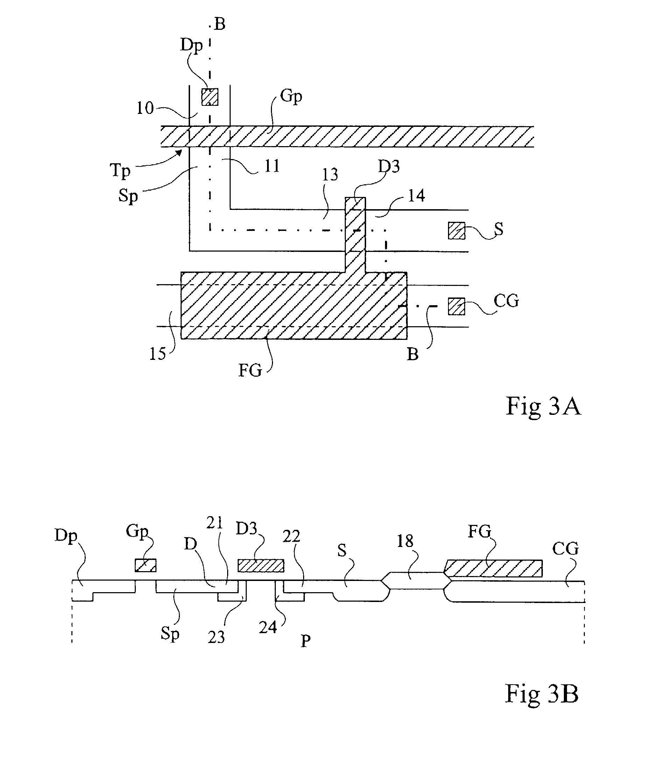

Dans les figures 3A et 3B, des éléments similaires à ceux représentés en figures 2A et 2B sont désignés par de mêmes références. La référence Gp désigne la grille du transistor de sélection, la référence Dp le drain du transistor de sélection, la référence Sp la source du transistor de sélection, ces éléments étant constitués comme précédemment. La référence FG désigne une portion de silicium polycristallin formée, par l'intermédiaire d'une couche isolante, au-dessus d'une région diffusée 15 de type N constituant la grille de commande CG de la cellule EEPROM, ces éléments étant disposés comme précédemment.

Contrairement à ce qui a été décrit précédemment, un seul doigt D3 de silicium polycristallin s'étend à partir de la grille flottante FG, ce doigt délimitant une zone de canal entre des portions 13 et 14 de type N correspondant au drain et à la source de la cellule EEPROM. Plus particulièrement, chacune des régions 13, 14 comprend une zone 21, 22 de type N relativement fortement dopée s'étendant sensiblement jusqu'à l'aplomb du doigt D3 et une zone 23 de type N plus faiblement dopée s'étendant partiellement sous le doigt D3 du côté du drain, comme le représente la vue en coupe de la figure 3B. On prévoira aussi de préférence, bien que cela soit optionnel une zone 24 de type N plus faiblement dopée s'étendant partiellement sous le doigt D3 du côté de la source. Une telle structure peut par exemple être obtenue en réalisant des implantations successives de phosphore et d'arsenic, par exemple à des densités d'implantation respectives de l'ordre de quelques 10¹⁴ atomes/cm² et de quelques 10¹⁵ atomes/cm². Pendant un recuit, la diffusion d'arsenic "pousse" la diffusion de phosphore et l'on obtient un profil de concentration tel que la concentration en surface à côté de la zone de grille et de l'ordre de 10¹⁹ atomes/cm³, la profondeur de jonction est de l'ordre de 0,4 à 0,5 µm et la pénétration sous la grille est de l'ordre de 0,3 µm. C'est-à-dire que l'on trouve de part et d'autre de la grille, une région de type N pénétrant sous cette grille d'une étendue de l'ordre de 0,3 µm.

Une autre différence entre la présente invention et l'état de la technique est que l'isolant sous le doigt de grille D3 est un oxyde très mince permettant l'obtention d'un effet tunnel, c'est-à-dire un oxyde de silicium d'une épaisseur de l'ordre de 60 à 80 µm.

Si dans l'art antérieur, le doigt de grille D1 avait une largeur (longueur de canal) de l'ordre de 1 µm, pour conserver les mêmes caractéristiques à la structure, le doigt de grille D3 selon l'invention aura une largeur de l'ordre de 1,6 µm (ou seulement de 1,3 µm si la région 24 du côté source est omise). Les tensions appliquées en programmation, en effacement et en lecture de la structure selon la présente invention seront les mêmes que celles mentionnées précédemment en relation avec les figures 2A et 2B. Pendant la programmation, tandis que le drain est à VPP, que la source est flottante et que la grille est à la masse, l'injection de charges dans la grille flottante se produit par les zones où le doigt D3 recouvre la partie d'extension de drain 23. Pendant l'effacement, tandis que le drain et la source sont à la masse et que la grille est à VPP, l'injection de charges dans la grille flottante se produit par les zones où le doigt D3 recouvre les parties d'extension de drain et de source 23 et 24.

Bien entendu, la présente invention est susceptible de diverses variantes et modifications qui apparaîtront à l'homme de l'art. Notamment les diverses valeurs numériques ont été données uniquement à titre d'exemple et ne doivent être considérées que comme des ordres de grandeur susceptibles de larges variation liées aux technologies de fabrication utilisées.

## Revendications

1. Cellule EEPROM (M) à un seul niveau de silicium polycristallin qui correspond à une grille flottante (FG) qui s'étend d'une part, par l'intermédiaire d'une première couche isolante au-dessus d'une région fortement dopée d'un premier type de conductivité constituant une grille de commande (CG), d'autre part, par l'intermédiaire d'une deuxième couche isolante pour former un doigt de grille (D3) au-dessus d'une zone de canal de la cellule,
caractérisée en ce que la deuxième couche isolante est une couche suffisamment mince pour donner lieu à un effet tunnel et en ce que la zone de drain (21, 23) de la cellule est à profil graduel et s'étend partiellement sous le doigt de grille.

2. Cellule EEPROM selon la revendication 1, caractérisée en ce que la zone de source (22, 24) de la cellule est également à profil graduel et s'étend partiellement sous le doigt de grille.

3. Cellule EEPROM selon la revendication 1, caractérisée en ce que la deuxième couche isolante est une couche d'oxyde de silicium d'une épaisseur de 50 à 80 nm.

4. Cellule EEPROM selon la revendication 2, caractérisée en ce que les zones de source et de drain résultent d'une implantation de phosphore à une première dose et d'arsenic à une deuxième dose plus élevée que la première dose, ces implantations étant suivies d'un recuit de redistribution de sorte que des atomes dopants de phosphore pénètrent sous les bords de la grille.

5. Cellule EEPROM selon la revendication 4, caractérisée en ce que la première dose est de l'ordre de quelques 10¹⁴ at./cm² et la deuxième dose de l'ordre de quelques 10¹⁵ at./cm².
